Europäisches Patentamt

European Patent Office

Office européen des brevets

(19)

(11) Numéro de publication : **0 446 546 A2**

## (12) DEMANDE DE BREVET EUROPEEN

(21) Numéro de dépôt : 90403626.6

(22) Date de dépôt : 17.12.90

(51) Int. Cl.⁵ : **G01K 7/02**

(30) Priorité : 19.12.89 FR 8916809

(43) Date de publication de la demande :
18.09.91 Bulletin 91/38

(84) Etats contractants désignés :
AT BE CH DE DK ES GB GR IT LI LU NL SE

(71) Demandeur : UNIVERSITE DES SCIENCES ET
TECHNIQUES DE LILLE FLANDRES-ARTOIS
(LILLE I)
Domaine Universitaire Scientifique
F-59655 Villeneuve d'Ascq Cedex (FR)

(72) Inventeur : **Thery, Pierre**
**45, rue de Lille**
**F-59650 Villeneuve D'Ascq (FR)**
Inventeur : **Leclercq, Didier**
**90, rue Coustou**
**F-59800 Lille (FR)**
Inventeur : **Wattiau, Francis**
**20, rue du Pron**
**F-59650 Villeneuve D'Ascq (FR)**

(74) Mandataire : **Fréchède, Michel**
**Cabinet Plasseraud 84, rue d'Amsterdam**
**F-75009 Paris (FR)**

(54) **Procédé et dispositif utilisant les effets thermoélectriques pour la mesure d'une grandeur physique dont la variation est apte à modifier les propriétés thermophysiques d'un milieu.**

(57) Le dispositif comprend au moins un circuit (31) constitué par une succession de deux types d'éléments (33, 34) conducteurs ou semiconducteurs en série, ces deux types ayant des pouvoirs thermoélectriques différents et étant disposés en alternance de manière à réaliser deux types de jonctions alternants de thermocouples ; une source de courant électrique unidirectionnel (41) ; des moyens (37) pour connecter cette source de courant aux bornes de ce circuit unique ou d'au moins de ces circuits, dit d'activation, pendant une première période de temps constituant une période d'activation ; des moyens (35) pour mesurer, pendant une seconde période de temps constituant une période de mesure, la différence de potentiel aux bornes de ce circuit unique ou d'au moins un de ces circuits, dit de mesure et différent dudit au moins un circuit auquel la source de courant est connectable, le ou les circuits de mesure étant thermiquement couplés au ou aux circuits d'activation ; et des moyens pour déterminer à partir de la mesure de cette différence de potentiel la variation à mesurer de ladite grandeur physique.

FIG.9.

# PROCEDE ET DISPOSITIF UTILISANT LES EFFETS THERMOELECTRIQUES POUR LA MESURE D'UNE GRANDEUR PHYSIQUE DONT LA VARIATION EST APTE A MODIFIER LES PROPRIETES THERMOPHYSIQUES D'UN MILIEU

La présente invention a pour objet un procédé mettant en oeuvre les effets thermoélectriques pour la mesure d'une grandeur physique dont la variation est apte à modifier les propriétés thermophysiques d'un milieu, ainsi qu'un dispositif mettant en oeuvre ce procédé.

Les principaux effets thermoélectriques, c'est-à-dire ceux produisant une modification de température sous l'effet du passage d'un courant électrique dans un circuit ou donnant naissance à une force électromotrice (f.e.m.) ou d'une force contre-électromotrice (f.c.e.m.) sous l'effet d'une différence de température entre deux points d'un circuit sont les suivants:

1°- L'effet Peltier qui se manifeste lorsqu'un conducteur électrique formé de deux portions conductrices différentes est traversé par un courant électrique: une variation de température (échauffement ou refroidissement) se produit dans la zone de contact entre les deux portions sous l'effet du passage du courant dans le conducteur, cette variation étant proportionnelle à l'intensité I du courant et s'inversant lorsque le sens du passage du courant s'inverse; il s'agit donc d'un effet réversible proportionnel à I, la puissance calorifique $P_p$ produite par cet effet étant de la forme $P_p = vI$, la quantité $\underline{v}$ jouant le rôle d'une f.e.m. localisée dans la zone de contact précitée et constituant la f.e.m. Peltier.

2°- L'effet Joule qui produit l'échauffement d'un conducteur traversé par un courant électrique, cet échauffement P' étant proportionnel au carré de l'intensité I du courant et à la résistance R du conducteur: $P_J = RI^2$, ce qui montre que l'effet Joule n'est pas un effet réversible, car il est fonction de $I^2$ (fonction paire qui ne change pas de signe lorsque I change de signe).

Il y a lieu de noter que lorsqu'un conducteur électrique formé de deux portions conductrices différentes est traversé par un courant électrique d'intensité I les deux effets Peltier et Joule se manifestent, la puissance calorifique totale mise en oeuvre étant $P_p + P_J = vI + RI^2$, avec un terme réversible (vI), positif ou négatif, et un terme irréversible ($RI^2$), toujours positif.

3°- L'effet Thomson qui se manifeste dans un conducteur dont les extrémités sont portées à des températures différentes: lorsque ce conducteur est traversé par un courant électrique il se produit une variation de température (échauffement ou refroidissement) qui est fonction de la différence de température et de l'intensité I du courant et qui s'inverse lorsque le sens du courant s'inverse; il y a donc production d'une f.e.m. de température qui est réversible.

L'effet Thomson est en général négligeable vis-à-vis de l'effet Peltier et également de l'effet Joule.

4°- L'effet Seebeck qui se manifeste dans un circuit fermé comportant deux portions constituées en deux matériaux conducteurs (métaux ou alliages) ou semiconducteurs différents pour former un couple thermoélectrique ou thermopile: lorsque les deux contacts entre les deux portions sont maintenues à des températures différentes, un courant électrique circule dans le circuit sous l'effet d'une f.e.m. ou plutôt d'une f.c.e.m. thermoélectrique engendrée par le couple, cette f.c.e.m., et donc l'intensité du courant, étant fonction de ladite différence de température.

On connaît, entre autres, deux sortes de dispositifs thermoélectriques pour la mesure de grandeurs physiques modifiant le milieu ambiant:

A. On a utilisé des thermocouples mettant en jeu l'effet Seebeck pour réaliser des capteurs de mesure, par exemple de la vitesse ou du débit d'écoulement d'un fluide (brevet français n° 2.575.831 de l'Université d'Orléans), ou du niveau d'un liquide dans un réservoir avec la coopération d'un élément chauffant disposé le long d'une paroi latérale du réservoir (brevet des Etats-Unis n° 4.796.471 de Monsieur Cullen M. Sabin cédé à Thermonetics Corporation), ainsi que des capteurs à fil chaud (chauffage par effet Joule) traversant la surface d'un liquide pour déterminer le niveau du liquide (demande de brevet européen publiée n° 0 249 521 de Bendix Electronics S.A.). Par ailleurs la demande de brevet européen publiée n° 0 070 801, déposée par Battelle Memorial Institute, réalise au moyen d'une sonde la mesure d'une grandeur physique qui influence le transfert thermique entre la sonde et le fluide, en plongeant dans celui-ci cette sonde, en la portant à un premier seuil de température, en repérant au moins un second seuil de temprature et en mesurant le temps écoulé entre le passage d'un seuil à l'autre; en particulier cette sonde peut être un élément Peltier qui engendre, lorsqu'il est parcouru par un courant électrique, une différence de température entre ses deux jonctions et cette différence, qui est fonction de ladite grandeur physique du fluide ambiant, peut être mesurée en utilisant l'effet Seebeck engendré dans la sonde, un interrupteur interrompant le courant électrique ayant produit l'effet Seebeck lorsque la différence de température a atteint un seuil prédéterminé.

B. On a réalisé des dispositifs de mesure d'un flux de chaleur traversant un bloc de matière

– soit en créant un flux de chaleur supplémentaire de valeur déterminée, par mise en oeuvre de l'effet Peltier, de manière que la somme algébrique du flux à mesurer et du flux supplémentaire traverse ledit bloc de matière, les différences de température entre deux plans parallèles limitant ledit bloc, qui est finalement fonction du flux de chaleur à mesurer, étant déterminée par un thermocouple mettant en oeuvre l'effet Seebeck (brevet français n° 2.458.802 de l'ANVAR);

– soit en réalisant un fluxmètre thermique qui transforme une énergie thermique (par radiation et convection) en une différence de potentiel dont on mesure les variations, ce qui permet une mesure, directe et en temps réel, des échanges d'énergie entre un système et son environnement; un tel fluxmètre comporte un très grand nombre de thermocouples (plusieurs centaines et de préférence plusieurs milliers de thermocouples) dont l'ensemble est réalisé sous la forme d'un circuit imprimé de très faible dimension (quelques dizaines de thermocouples sur un mm² de surface), facilement industrialisable et hautement sensible; la disposition géométrique des thermocouples en série est de préférence méandriforme et comporte avantageusement, sur un support en une matière isolante, un ruban méandriforme en une première matière conductrice ou semi-conductrice et des îles de revêtement en une seconde matière conductrice ou semi-conductrice différente de la première, une dissymétrie structurale étant prévue dans le sens du ruban, c'est-à-dire de la succession des thermocouples et donc d'îles de revêtement (brevets français n° 2.471.055, 2.536.536 et 2.598.803 de l'ANVAR, Monsieur Pierre Théry, l'un des inventeurs de la présente invention, étant l'un des inventeurs désignés dans ces trois brevets français).

La présente invention met essentiellement en oeuvre à la fois l'effet Peltier, pour produire des différences de température entre les zones de jonction alternés d'une succession de couples de conducteurs ou semiconducteurs en série, et l'effet Seebeck, pour déterminer les différences de température entre ces zones alternées du fait de l'effet Peltier et des influences thermiques dues au milieu ambiant, différences qui dépendent de la grandeur physique à mesurer dont les variations provoquent ces influences.

L'invention a tout d'abord pour objet un procédé pour mesurer une grandeur variable apte à influencer thermiquement un milieu, caractérisé par le fait que l'on utilise au moins un circuit thermoélectrique comportant en série une pluralité de thermocouples élémentaires et apte donc à mettre en oeuvre à la fois l'effet Peltier et l'effet Seebeck, qu'on fait circuler, pendant une période dite d'activation, à travers ce circuit ou au moins un des circuits, un courant électrique unidirectionnel pour engendrer, par effet Peltier, aux jonctions des thermocouples du ou des circuits traversés par le courant, des modifications de températures, positives en une partie de ces jonctions et négatives en l'autre partie de ces jonctions, et qu'on détermine, pendant une période dite de mesure qui suit ladite période d'activation, la différence de potentiel engendrée par l'effet Seebeck aux bornes du circuit unique ou d'au moins un autre de ces circuits (thermiquement couplé à au moins un circuit traversé par ledit courant), en l'absence d'application de courant aux bornes de ce ou ces circuits de mesure.

L'invention a également pour objet un dispositif pour la mise en oeuvre du procédé précité, caractérisé par le fait qu'il comporte en combinaison:

– au moins un circuit constitué par une succession de deux types d'éléments conducteurs ou semiconducteurs en série, ces deux types ayant des pouvoirs thermoélectriques différents et étant disposés en alternance de manière à réaliser deux types de jonctions alternants de thermocouples;

– une source de courant électrique unidirectionnel;

– des moyens pour connecter cette source de courant aux bornes de ce circuit unique ou d'au moins de ces circuits, dit d'activation, pendant une première période de temps constituant une période d'activation;

– des moyens pour mesurer, pendant une seconde période de temps constituant une période de mesure, la différence de potentiel aux bornes de ce circuit unique ou d'au moins un de ces circuits, dit de mesure et différent dudit au moins un circuit auquel la source de courant est connectable, le ou les circuits de mesure étant thermiquement couplés au ou aux circuits d'activation; et

– des moyens pour déterminer à partir de la mesure de cette différence de potentiel la variation à mesurer de ladite grandeur physique.

Avantageusement le circuit électrique est constitué par un circuit imprimé comportant, sur un support, en une matière isolante, un ruban méandriforme en une première matière conductrice (telle que l'alliage dénommé "constantan") et, sur ce ruban, des îles de revêtement disposées l'une derrière l'autre, mais séparées les unes des autres dans le sens du ruban, le revêtement étant réalisé en une seconde matière conductrice (telle que le cuivre), beaucoup plus conductrice de l'électricité que la première.

L'invention pourra, de toute façon, être bien comprise à l'aide du complément de description qui suit, ainsi que des dessins ci-annexés, lesquels complément et dessins sont, bien entendu, donnés surtout à titre d'indication.

La figure 1 représente en coupe, schématiquement et partiellement, une succession d'éléments conducteurs ou semi-conducteurs, de deux types alternants qui ont des pouvoirs thermoélectriques différents, avec des zones de contact également de deux types alternants, succession mise en oeuvre dans le procédé et le dispositif selon l'invention.

La figure 2 illustre un schéma électrique équivalent à la structure de la figure 1.

La figure 3 représente, partiellement et en perspective avec coupe, un mode de réalisation particulièrement avantageux d'une succession selon la figure 1, du type "circuit imprimé".

La figure 4 illustre un schéma électrique équivalent à une portion de la structure de la figure 3.

La figure 5 illustre, vue en plan, une disposition méandriforme préférée de la succession d'éléments conducteurs alternants, mise en oeuvre dans le procédé et le dispositif selon l'invention.

Les figures 6, 7 et 8 représentent, en perspective avec coupe, trois phases d'un procédé de fabrication d'une succession d'éléments conducteurs selon la réalisation de la figure 3.

Les figures 9, 10, 11 et 12 représentent des schémas de circuits électriques associables à une succession d'éléments conducteurs ou semiconducteurs pour réaliser un dispositif selon l'invention.

La figure 13 illustre la variation, au cours du temps, de la différence de potentiel d'alimentation du dispositif de la figure 12.

Les figures 14, 15 et 16 illustrent, vus en plan, trois modes de réalisation particuliers d'une succession d'éléments conducteurs alternants mettant en oeuvre une structure du type "circuit imprimé".

La figure 17 représente, en coupe, un autre mode de réalisation d'une succession d'éléments de deux types, dans lequel on met en oeuvre une structure du type "circuit intégré".

Les figures 18, 19, 20 et 21 représentent, partiellement et en perspective avec coupe, quatre modes de réalisation d'un ensemble de plusieurs circuits thermoélectriques constitués par une succession d'éléments conducteurs et/ou semiconducteurs alternants.

La figure 22 illustre un dispositif (jauge) qui montre l'application de l'invention à la mesure du niveau d'un liquide dans un récipient.

La figure 23 illustre un dispositif qui matérialise l'application de l'invention à la mesure de la vitesse de déplacement et/ou du débit d'un fluide.

La figure 24 représente un dispositif qui matérialise l'application de l'invention à la détermination du point de rosée d'une vapeur ou d'un gaz humide.

La figure 25 représente schématiquement l'application de l'invention à un compteur de calories.

La figure 26 est un schéma électrique illustrant un circuit qui permet de compenser les dérives produites par les variations de température dans un circuit thermoélectrique mettant en oeuvre l'invention.

Selon l'invention et plus spécialement selon celui de ses modes d'application, ainsi que selon ceux des modes de réalisation de ses diverses parties, auxquels il semble qu'il y ait lieu d'accorder la préférence, se proposant, par exemple, de réaliser un procédé et un dispositif utilisant les effets thermoélectriques pour la mesure d'une grandeur physique dont la variation est apte à modifier les propriétés thermophysiques d'un milieu, on s'y prend comme suit ou d'une manière analogue.

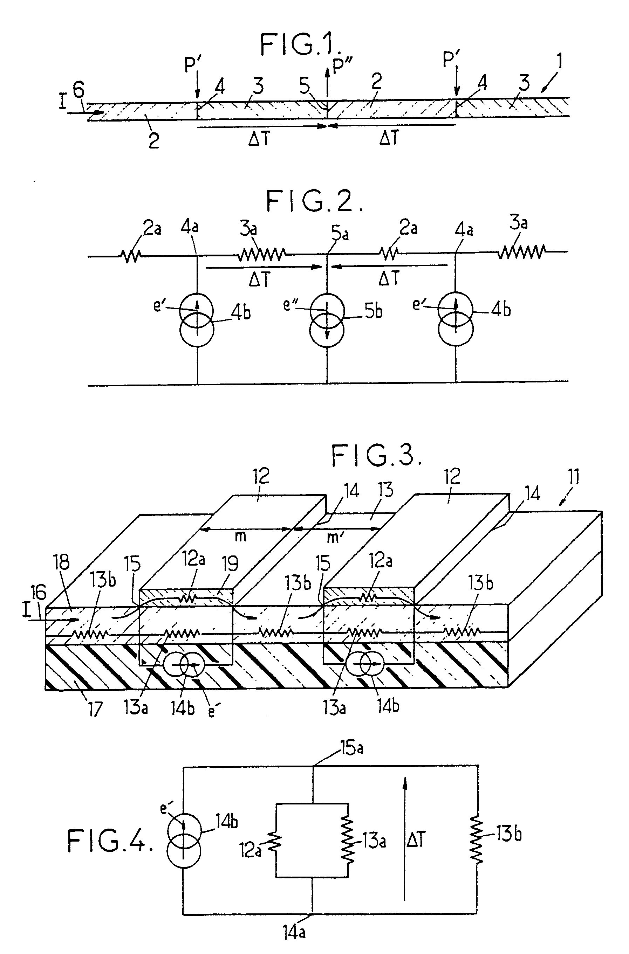

Sur la figure 1 on a représenté une portion d'un ruban métallique 1 constituée par deux types de conducteurs différents 2 et 3 ayant des pouvoirs thermoélectriques différents et se trouvant initialement à la même température; en 4 et 5 se trouvent les zones de contact (par exemple par soudure) entre les conducteurs 2 et 3, la référence 4 désignant une zone de contact pour laquelle un conducteur 2 se trouve à gauche d'un conducteur 3, tandis que la référence 5 désigne une zone de contact pour laquelle un conducteur 3 se trouve à gauche d'un conducteur 2.

Lorsqu'on fait circuler un courant électrique, représenté par la flèche 6, d'intensité I et dirigé de la gauche vers la droite, on observe le dégagement d'une quantité de chaleur au niveau d'un type de zone de jonction et une absorption d'une quantité rigoureusement égale de chaleur au niveau de l'autre type de zone de jonction. On a représenté par des flèches P' et P" respectivement l'absorption et l'émission de chaleur, étant entendu que les quantités de chaleur P' et P" sont proportionnelles à l'intensité I du courant 6.

Dans le cas où de la chaleur est dégagée aux jonctions 5 et absorbée aux jonctions 4, des différences de température $\Delta T$ (dans des sens opposés et de même grandeur) se manifestent, comme illustré sur cette figure 1, avec production de flux thermiques de conduction.

Sur la figure 2 on a illustré le schéma électrique équivalant à la portion de ruban de la figure 1:

les conducteurs 2 et 3 sont représentés par les résistances équivalentes 2a et 3a, en supposant qu'un conducteur 2 a une résistivité beaucoup plus faible qu'un conducteur 3,

les zones de jonction 4 et 5 sont figurées en 4a et 5a respectivement, et

les f.e.m. aux jonctions thermoélectriques 4 et 5 sont représentées par des générateurs 4b et 5b, respectivement de f.e.m. e' et e" de grandeur égale, mais de sens opposés.

Si l'on suppose tout d'abord que le circuit thermoélectrique, dont une partie a été illustrée sur la figure 1, est thermiquement isolé du milieu ambiant extérieur, c'est-à-dire si les échanges thermiques avec l'extérieur ne viennent pas compenser les sources thermiques froides et chaudes dues à l'effet Peltier, la température des jonctions d'un des types (4 dans l'exemple choisi) diminue, tandis qu'à l'autre type de jonction (5 dans l'exemple choisi) la température s'élève, la puissance thermique engendrée par effet Peltier étant intégralement convertie en variations de températures qui sont réversibles si l'on inverse le sens du courant 6.

Dans ce cas le circuit thermoélectrique ne reste pas isotherme, les différences de températures $\Delta T$ produites entre les jonctions de deux types ne dépendant que des propriétés thermiques et thermoélectriques du circuit dans lequel se produisent d'ailleurs des échauffements par effet Joule et la mise en oeuvre de l'effet Thomson, ainsi qu'un transfert thermique par conduction entre sources chaudes et froides.

On peut remarquer qu'il est possible, dans le cas d'un circuit thermoélectrique de ce type, thermiquement isolé du milieu extérieur, de mesurer la différence de température entre une jonction 4 et une jonction 5, par exemple par la mise en oeuvre de l'effet Seebeck, soit au moyen d'un thermocouple autre que la channe de thermocouples élémentaires illustrée partiellement sur la figure 1, soit au moyen de cette chaîne, comme expliqué ci-après, de manière à déterminer les caractéristiques thermiques et thermoélectriques du ruban 1.

Dans le cas contraire, c'est-à-dire si le circuit thermoélectrique 1 échange de l'énergie avec le milieu environnant à travers la surface limite du circuit thermoélectrique, une partie de la puissance thermique engendrée par effet Peltier reste localisée au voisinage du circuit 1 dans le milieu environnant, les différences de températures entre une jonction 4 et une jonction 5 étant produites par effet Peltier, comme précédemment, mais dépendant en outre non seulement des caractéristiques du circuit 1 proprement dit, mais également des propriétés physiques du milieu environnant.

C'est sur cette possibilité de mesure des propriétés physiques du milieu environnant qu'est basé le procédé et le dispositif selon la présente invention mettant en oeuvre un circuit thermoélectrique du type illustré schématiquement sur la figure 1, notamment selon les modes de réalisation indiqués ci-dessous.

On peut ainsi mesurer une grandeur physique modifiant les propriétés thermophysiques du milieu qui entoure le circuit thermoélectrique, par la mesure des différences de températures entre des jonctions telles que 4 d'une part et 5 d'autre part induites par le passage d'un courant électrique 6 dans ce circuit.

Pour avoir une bonne sensibilité il y a intérêt à utiliser des circuits thermoélectriques de faible épaisseur, de manière à optimiser les échanges énergétiques (thermiques) entre le milieu environnant et le circuit 1 à travers la surface limite de ce circuit.

Pratiquement on a intérêt à réaliser le circuit 1 sous la forme d'un circuit imprimé ou intégré à conducteurs métalliques ou semiconducteurs.

Du fait qu'il est difficile de réaliser industriellement des mises en contact électrique par soudure de deux conducteurs métalliques de pouvoirs thermoélectriques différents dans un circuit imprimé métallique, on construit, selon un mode de réalisation particulièrement avantageux, le circuit 11 comme illustré sur la figure 3 au moyen d'un ruban métallique continu 13 de faible épaisseur, en une première matière conductrice, par exemple en l'alliage connu sous le nom de "constantan", recouvert sur une de ses faces (la face supérieure sur la figure 3) par une succession de dépôts électrolytiques ou électrodes 12 espacés, en une seconde matière conductrice qui est beaucoup plus conductrice de l'électricité que la première matière et qui possède un pouvoir thermoélectrique différent de celui de la première matière, par exemple en cuivre, ces dépôts électrolytiques ou électrodes formant des îles séparées l'une de l'autre.

Etant donné la différence de conductivité du cuivre et du constantan (par exemple pour un ruban 13 en constantan épais de 25 µm la résistance de surface est de 20 mΩ, tandis que pour un dépôt électrolytique de cuivre épais de 5 µm la résistance de surface est de l'ordre de 3 mΩ), les dépôts életrolytiques de cuivre jouent le rôle de "court-circuits électriques" disposés sur la surface du ruban continu 13 en constantan et pratiquement le circuit thermoélectrique 11 est constitué par une succession de conducteurs métalliques en cuivre 12 et en constantan 13 alternants, comme pour le ruban de la figure 1, en supposant que les conducteurs 2 sont en cuivre et les conducteurs 3 en constantan.

Sur la figure 3 on a illustré les résistances 12a des dépôts de cuivre 12 et les résistances 13a et 13b (de même valeur si la largeur m des dépôts est égale à l'écart m' entre dépôts successifs), chaque résistance 12a étant en parallèle avec une résistance correspondante 13b sous-jacente, d'une part, et les ensembles parallèles 12a-13a étant disposés en série avec les résistances 13b, d'autre part. Sur la figure 3 on a également représenté en 14 les f.e.m. dues à l'effet Peltier entre deux jonctions successives 15 et 14.

Dans la réalisation pratique l'ensemble du ruban 13 en constantan et des dépôts électrolytiques 12 en cuivre est porté par un support 17, par exemple en la matière plastique isolante dénommée "Kapton", qui se trouve contre la face du ruban 13 non recouverte de dépôts électrolytiques 12.

La figure 4 illustre le schéma électrique correspondant au dispositif de la figure 3.

Dans le cas d'un circuit imprimé bimétallique à ruban continu mince 13 et électrodes très minces 12, déposées électrolytiquement, du type illustré sur la figure 3, les échanges énergétiques avec le milieu environnant sont favorisés du fait de la faible épaisseur du circuit imprimé et de l'importance relativement grande des échanges de type radiatif, convectif et/ou conductif à travers la surface supérieure des dépôts 12 et des parties du ruban 13 non recouvertes de dépôts 12 et à travers les surfaces latérales telles que 18 et 19 du ruban 13 et des dépôts 12 respectivement, relativement aux échanges conductifs suivant la longueur du circuit 11.

Sur la surface d'un tel circuit 11 parcouru par un courant électrique 16 de faible intensité I sont distribuées des sources énergétiques (entretenues par effet Peltier) échangeant de l'énergie avec le milieu environnant.

Le couplage entre sources énergétiques étant fonction des propriétés thermiques du milieu environnant, les écarts de température entre jonctions thermoélectriques sont fonction des positions relatives des zones où il y a émission et des zones où il y a absorption d'énergie, aussi bien suivant la direction axiale que suivant la direction transversale puisque deux sources énergétiques de signe contraire situées sur deux pistes voisines sont thermiquement couplées par le milieu environnant.

Lorsque le circuit thermoélectrique 11 est placé dans un milieu dans lequel on veut mesurer une grandeur physique, l'énergie échangée par effet Peltier au niveau de chaque jonction 14, 15 peut être transférée directement dans le milieu sans modifier de façon sensible les écarts de température entre jonctions thermoélectriques. Dans ce cas la différence de température entre jonctions dépend de la quantité d'énergie extraite du circuit thermoélectrique, ou éventuellement fournie au circuit, et permet la caractérisation du mécanisme d'extraction, ou éventuellement de fourniture, de l'énergie.

Un circuit imprimé bimétallique 11 traversé par un courant 16 de faible intensité peut donc être assimilé à une distribution de sources énergétiques localisées sur la surface du circuit bimétallique (figure 3 et 4). Ces sources sont modélisables par des générateurs de courant (ou source de courant), tels que 14b, idéaux couplés entre eux par les résistances, telles que 12a, 13a, 13b, du circuit thermoélectrique et le milieu environnant. Les écarts de température entre jonctions thermoélectriques dépendent directement du couplage entre sources de courant et peuvent être mesurés, par exemple par effet Seebeck.

On peut ainsi, comme cela sera exposé en détail ci-après, réaliser par mise en oeuvre de l'invention:

     – un capteur déterminant le niveau du liquide dans un réservoir, basé sur fait que la quantité d'énergie thermique transférée dans le liquide, d'une part, et dans le volume gazeux surmontant le liquide, d'autre part, dépend de l'importance de la portion de circuit thermoélectrique immergée dans le fluide;

     – un capteur de débit massique d'un courant fluide et/ou de la vitesse d'un courant fluide, basé sur le fait que la quantité d'énergie thermique transférée du circuit thermoélectrique au débit fluide dans lequel est placé le circuit dépend du débit et/ou de la vitesse du courant fluide;

     – un détecteur de changement d'état (congélation, point de rosée, etc.), basé sur la mesure de la perturbation des propriétés thermiques du milieu environnant lorsque celui-ci change d'état physique;

     – un compteur de calories.

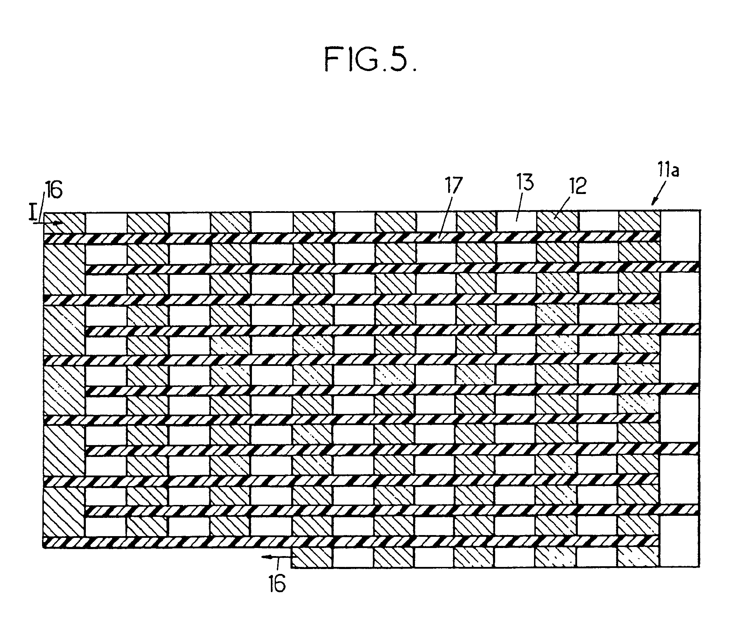

Sur la figure 5 on a illustré une disposition géométrique particulièrement avantageuse du circuit thermoélectrique selon l'invention, à savoir un circuit méandriforme 11a.

La figure 5 est une vue en plan sur laquelle on retrouve le support en Kapton 17, de section sensiblement rectangulaire, sur lequel est disposé le ruban 13 en constantan, par exemple, qui est de type méandriforme, et la succession de revêtements électrolytiques 12, par exemple en cuivre, le courant électrique 16 d'intensité I circulant comme indiqué sur la figure 5, qui en fait ne représente qu'une partie du circuit thermoélectrique qui peut comporter plusieurs centaines ou milliers de thermocouples et par conséquent plusieurs centaines ou milliers de dépôts électrolytiques 12.

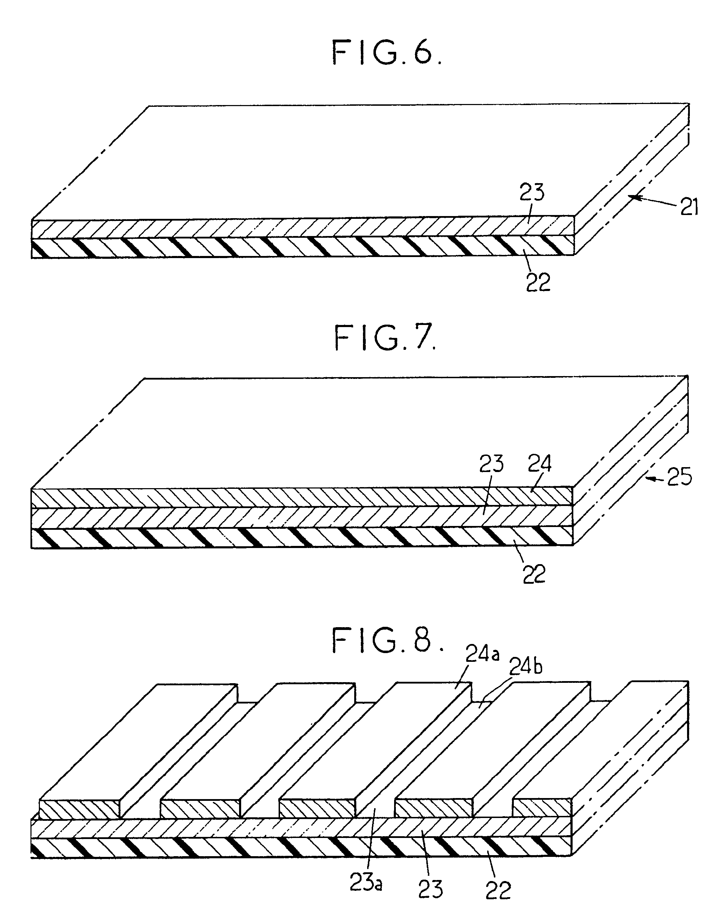

Le circuit des figures 3 et 5 peut être réalisé de la manière suivante avec référence aux figures 6 à 8.

On utilise comme matière de base une feuille 21 du commerce (figure 6) comportant une plaquette de support mince en Kapton 22, épaisse de 50 μm, sur laquelle est collée une pellicule de constantan 23, épaisse de 25 μm.

La première opération consiste à déposer par électrolyse, sur la feuille du commerce 21, une couche très mince 24, de cuivre, épaisse de 5 μm, et on obtient ainsi la feuille 25 à trois couches de la figure 7, à savoir couche de Kapton 22, couche de constantan 23 et couche de cuivre 24.

On enlève ensuite par gravure chimique, à l'aide d'un masque et au moyen d'un acide dissolvant du cuivre, mais non du constantan, des portions du revêtement électrolytique 24 en cuivre, pour ne laisser que des zones 24a de revêtement de cuivre séparées par des espaces 24b dans lesquels la couche de constantan 23 n'est pas revêtue de cuivre. On obtient ainsi la structure de la figure 8.

Un nouveau traitement au perchlorure de fer, qui attaque à la fois les zones 24a cuivrées et les zones 23a de constantan non cuivrées, non protégées par un second masque, permet de donner à l'ensemble du circuit la forme géométrique désirée, par exemple celle illustrée sur la figure 5.

On va donner maintenant quelques détails sur les propriétés électriques et thermoélectriques d'un circuit selon les figures 3 et 5, dans lequel le ruban continu 13 est en constantan et les dépôts 12 sont en cuivre électrolytique.

Le constantan, élément de base du circuit imprimé des figures 3 et 5, est un alliage cuivre-nickel dont la résistivité dépend de la proportion des éléments constituant l'alliage. D'un point de vue électrique, l'alliage particulier choisi est caractérisé par sa résistivité $r_1 = 5.10^{-7}$ Ω/m.

La résistance électrique d'un tronçon de longueur L, de largeur I et d'épaisseur e est

$$R = \frac{r_1}{e} \times \frac{L}{l} = r \, (L/l)$$

C'est le produit d'une quantité purement géométrique (L/l) par la résistance de surface ($r_1/e$), désignée r, qui se mesure en Ω. La résistance de surface r caractérise la conduction électrique du ruban de constantan 13 dans le circuit imprimé, compte-tenu de son épaisseur.

Pour les circuits résistifs en constantan utilisés épais de 25 μm, r = 20 mΩ.

Le cuivre électrolytique déposé en tant qu'îles 12 sur le ruban méandriforme 13 en constantan peut être considéré comme un matériau dont les propriétés sont très voisines de celles du cuivre homogène.

Compte-tenu du contraste entre les conductivités électriques du cuivre et du constantan, la résistance de surface d'un dépôt électrolytique est beaucoup plus faible que celle du constantan sous-jacent; par exemple pour une épaisseur de 5 μm de dépôt de cuivre, la résistance de surface est de l'ordre de 3 mΩ. Le dépôt électrolytique joue donc le rôle de "court-circuit électrique" par rapport au constantan sous-jacent. Lorsque le circuit thermoélectrique est traversé par un courant électrique, la presque totalité des lignes de courant passe du support en constantan faiblement conducteur dans les dépôts en cuivre de grande conductivité et inversement au voisinage des lignes frontières des régions cuivrées. Tout se passe donc comme si le circuit méandriforme était constitué par une succession de tronçons métalliques en cuivre et en constantan qui alternent en étant en contact électrique par leurs extrémités, qui forment des jonctions de thermocouple. Le support métallique sous-jacent dans les zones revêtues de dépôts électrolytiques ne joue donc aucun rôle du point de vue électrique lorsque la résistance électrique des dépôts est très faible vis-à-vis de celle du ruban en constantan faiblement conducteur.

Le passage du courant électrique dans le circuit précité est à l'origine de plusieurs types d'intéractions énergétiques:

    – la dissipation de chaleur $P_J$ par effet Joule est proportionnelle au carré de l'intensité du courant dans le circuit thermoélectrique de résistance totale $R_c$: $P_J = R_c I^2$,

    – la puissance thermique $P_p$ réversible produite par effet Peltier localisé sur les surfaces de contact des deux constituants du circuit traversées par le courant électrique est propritionnelle à l'intensité du courant court-circuité pour les électrodes de grande conductivité électrique.

$$P_p = (a_2 - a_1) \, T.I$$

($a_2 - a_1$) étant le pouvoir thermoélectrique du couple cuivre-constantan (en volts), T la température absolue (en degrés Kelvin) et I l'intensité (en ampères) du courant électrique.

Compte-tenu de la polarité du couple cuivre-constantan, il y a dégagement d'énergie lorsque le courant passe du cuivre dans le constantan et, inversement, absorption lorsque le courant repasse du constantan dans l'électrode en cuivre.

Lorsque le circuit thermoélectrique est thermiquement isolé du milieu environnant, les puissances $P_J$ et $P_p$ produisent des gradients de température dans le circuit thermoélectrique qui ne reste pas isotherme.

La puissance $P_p$ produite par effet Peltier au niveau des jonctions thermoélectriques engendre des différences de températures réversibles entre les zones frontières des électrodes en cuivre, différences qui sont proportionnelles à l'intensité I du courant inducteur, tandis que la puissance Joule $P_J$ distribuée dans tout le circuit bimétallique engendre un échauffement localement proportionnel à la résistance $R_c$ du circuit bimétallique; des différences de température peuvent être induites entre jonctions thermoélectriques par cette dissipation électrique interne par effet Joule, mais ces écarts ne sont pas réversibles puisque la puissance dissipée par effet Joule dépend du carré de l'intensité du courant électrique circulant dans le circuit bimétallique.

Les écarts de température entre jonctions thermoélectriques peuvent donc être considérés comme la superposition d'une composante réversible et d'une composante irréversible.

Dans le cas particulier d'un circuit imprimé traversé par un courant de faible intensité, l'effet de la dissipation interne par effet Joule peut être négligé vis-à-vis des échanges par effet Peltier.

Soit, à titre d'exemple, un circuit thermoélectrique selon les figures 3 et 5 ayant des régions 13 non cuivrées de forme carrée de 1 mm x 1 mm, de résistance électrique de 20 mΩ. Pour une épaisseur de dépôt électrolytique de 5 μm (de résistance 3 mΩ), la longueur des régions cuivrées 12 est prise égale à 7 mm de façon que les résistances électriques des parties cuivrées et non cuivrées soient égales entre elles (égales à 20 mΩ).

Lorsque le circuit est parcouru par un courant 16 d'intensité I égale à 1 mA, la puissance dissipée par effet Joule dans chacune des cellules du circuit est très faible, à savoir $P_J = 40.10^{-9} \times 10^{-6}$ W = $40.10^{-9}$ W, et nettement inférieure à la puissance produite par effet Peltier dans la cellule, à savoir $P_p = (a_2 - a_1)T.I$ = 12 μW à la température T = 300°K.

L'effet de l'échauffement interne du circuit peut donc être négligé et le circuit qui ne reste pas isotherme est soumis à des écarts réversibles de température.

Dans le cas particulier d'un circuit thermoélectrique isolé du milieu environnant, les écarts de température ne dépendent que de la résistance thermique du circuit bimétallique et peuvent être calculés en utilisant en première approximation le circuit thermique équivalent à résistances thermiques localisées de valeur $r_{th}$ = 2000 K/W.

Les résistances de chacune des paires de tronçons cuivré et non cuivré sous-jacent étant connectées en parallèle, la résistance thermique entre jonctions bimétalliques est de l'ordre de 1000 K/W et l'écart réversible de température entre deux jonctions consécutives, qui est de l'ordre de 12 mK pour un courant inducteur de 1 mA, peut être calculé en utilisant le circuit à résistances thermiques localisées de la figure 4.

La détermination rigoureuse des écarts de température entre jonctions bimétalliques nécessite le tracé des lignes de courant électrique inducteur et la localisation des points de passage du courant électrique à travers la surface de contact bimétallique dans laquelle sont localisés les échanges par effet Peltier. Les lignes de courant et les surfaces équipotentielles sont déterminées par résolution de l'équation de Laplace, compte-tenu des conditions limites: isolation sur les faces extérieures du circuit, courants imposés à travers les surfaces de section droite.

Compte-tenu de la complexité du problème, on peut utiliser une méthode de résolution numérique.

La solution peut être caractérisée par le fait que, quelle que soit l'épaisseur de l'électrode de cuivre, le courant électrique passe brutalement du support continu en constantan dans le dépôt en cuivre de grande conductivité et les lignes de courant sont pratiquement parallèles entre elles dans les conducteurs superposés. La distance nécessaire à l'établissement des lignes de courant suivant la direction parallèle au plan de lamination est de l'ordre de 50 μm à partir de la ligne frontière des électrodes en cuivre. La section de passage des lignes de courant du ruban en constantan dans les dépôts en cuivre est donc située au voisinage des frontières des régions cuivrées. Les échanges par effet Peltier sont localisées aux endroits où les lignes de courant traversent l'interface bimétallique et peuvent être modélisés par une distribution de sources d'énergie localisées.

Connaissant la distribution des sources réversibles induites par effet Peltier, la détermination du champ de température dans les conducteurs du circuit nécessite la résolution de l'équation de Fourier dans les volumes des conducteurs du circuit métallique et des matériaux environnants, puisque les lignes de flux thermique peuvent s'épanouir en dehors du circuit bimétallique lorsqu'il n'y a pas isolation thermique sur la surface du circuit thermoélectrique.

La modélisation numérique permet de relier les écarts réversibles de température localisés sur le circuit thermoélectrique imprimé à la perturbation des propriétés physiques du milieu environnant.

Il résulte de ce qui précède qu'un circuit imprimé bimétallique du type décrit avec référence aux figures 3 et 5 peut être utilisé successivement:

– comme générateur de différences de température, distribuées sur la surface du circuit, produites essentiellement par effet Peltier en circuit fermé, lorsqu'il est traversé par un courant électrique, et

– comme détecteur de ces différences de température par effet Seebeck en circuit ouvert.

La f.e.m. induite par effet Seebeck est en fait une force contre-électromotrice (f.c.e.m.), puisqu'elle représente un effet régulateur naturel qui s'oppose au courant électrique qui lui a donné naissance (on peut en effet considérer l'effet Seebeck comme résultant des effets Peltier et Thomson). En fait, le coefficient de couplage thermoélectrique des circuits imprimés bimétalliques est faible et la f.c.e.m. d'origine thermoélectrique est difficile à mettre en évidence en régime permanent de passage du courant électrique d'intensité I.

Si on prend à titre d'exemple le circuit bimétallique précédent avec des cellules élémentaires, ayant chacune une résistance électrique de 40 mΩ, traversées par un courant 16 d'intensité I égal à 1 mA:

– la f.e.m. nécessaire à l'entretien du passage du courant dans la cellule est de 40 μV,

– la puissance produite par effet Peltier $P_p$ étant (comme calculé précédemment) de 12 μW et la résistance thermique entre jonctions bimétalliques de 1000 K/W (voir aussi ci-dessus) la différence de température correspodante est de 12 μW.1000 K/W = $12.10^{-3}$°C,

– pour une différence de température de $12.10^{-3}$°C, la f.c.e.m. thermoélectrique est de $460.10^{-9}$ V, soit 100 fois plus faible que la f.e.m. nécessaire pour faire passer le courant.

On aura donc pour la différence de potentiel $\Delta V_c$ aux bornes du capteur la valeur

$$\Delta V_c = R_c I + n.a.\Delta T$$

$R_c$ = résistance ohmique du circuit thermoélectrique,

I = courant électrique inducteur,

n = nombre de cellules du circuit bimétallique,

$\Delta T$ = différence de température moyenne entre les jonctions thermoélectriques du circuit,

a = $a_1 - a_2$ = pouvoir thermoélectrique du circuit bimétallique avec, compte-tenu des résultats précédents:

$$R_c I \gg 100 (n.a.\Delta T)$$

La façon la plus simple de mesurer la f.c.e.m., égale à n.a.ΔT, figurant dans l'expression précédente serait de faire passer un courant d'intensité égale à I dans une résistance auxiliaire $R_c'$ de façon à obtenir une chute ohmique de valeur $V_h = R_c'I$ et d'amplifier la différence $V_c - V_h$ = n.a.ΔT supposée vérifiée lorsque la condition $R_c' = R_c$ est satisfaite.

On pourrait essayer de mesurer la différence $V_c$ - $V_h$ en utilisant un amplificateur différentiel; mais une telle mesure n'est pas reproductible, du fait que la valeur $R_c'$ de la résistance de référence, qui détermine la chute ohmique $V_h$, ne varie pas de la même façon que $R_c$ en fonction de la température. La variation en température de la résistance ohmique du capteur est due à la variation de la résistivité des électrodes en cuivre en fonction de la température. Toute variation $\theta$ de la température du circuit est de ce fait associée à une variation de résistance électrique et le passage du courant I engendre une tension de déséquilibre ou dérive de température $\Delta V = (R_c(\theta) - R_c')I$ qui se superpose à la tension à mesurer $n.a.\Delta T$. La dérive en température $\Delta V$ étant beaucoup plus importante que la f.c.e.m. thermoélectrique $n.a.\Delta T$, la différence $V_c$ - $V_h$ est aléatoire et rend pratiquement impossible la détermination de la f.c.e.m. égale à $n.a.\Delta T$.

Ceci montre que la dérive en température de la résistance ohmique $R_c$ est un phénomène parasite qui fausse la mesure des différences de température d'origine thermoélectrique.

Pour éliminer l'effet de la dérive en température sur la mesure de la f.c.e.m. thermoélectrique par effet Seebeck, il faut interrompre le passage du courant d'intensité I pendant la mesure, de façon à annuler la chute ohmique $R_c I$ qui seule dépend des variations de la température moyenne du circuit.

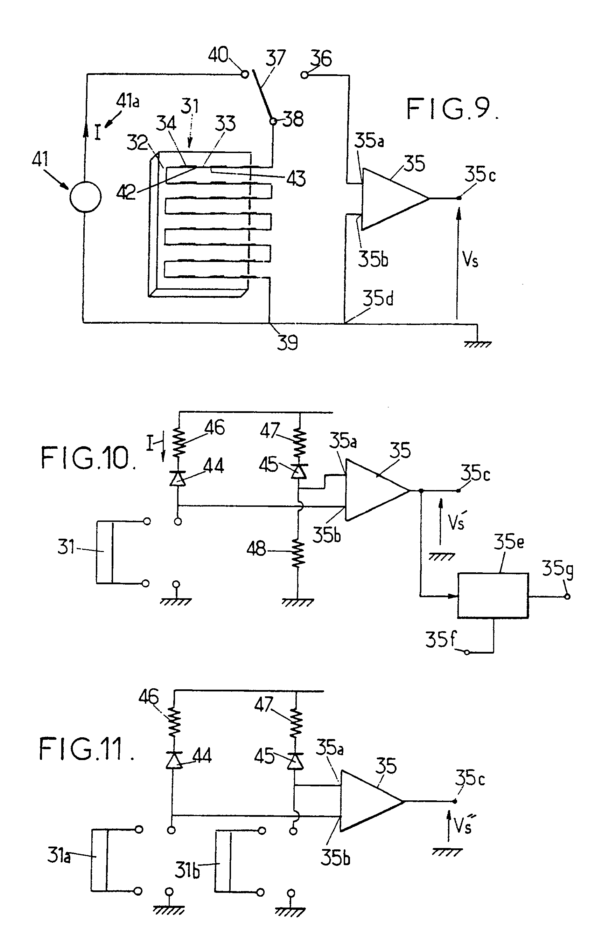

Sur la figure 9 on a illustré un schéma théorique pour réaliser la commutation entre une phase d'activation et une phase de mesure.

Dans le montage de la figure 9 on a représenté en 31 un dispositif thermoélectrique selon l'invention constitué de manière schématique par une plaquette de kapton 32, un ruban en constantan 33 et des dépôts électrolytiques de cuivre 34.

La mesure de la f.c.e.m. Seebeck est effectuée au moyen d'un amplificateur différentiel 35 dont l'une des entrées 35a (l'entrée positive) est reliée à la borne d'entrée 36 du circuit de mesure et dont la seconde entrée (négative) 35b est connectée en 35d à la masse.

La commutation est schématisée par un interrupteur dont la palette mobile 37 est connectée en permanence à une première extrémité 38 du circuit 31, dont la seconde extrémité 39 est à la masse. La palette mobile 37 peut occuper deux positions: dans sa première, elle est au contact de la borne 40 pour la période d'activation du circuit thermoélectrique 31, tandis que dans sa seconde position elle se trouve au contact de la borne 36 précitée pour la période de mesure.

Enfin un générateur de tension 41 produit un courant électrique 41a d'intensité I qui alimente, au moins pendant la période d'excitation, le circuit thermoélectrique 31.

Dans une première période dite d'activation, la palette 37 du relais appuie contre la borne 40 et de ce fait le courant 41a d'intensité I est appliqué entre les extrémités 38 et 39 du circuit thermoélectrique 31. Il en résulte, comme expliqué précédemment, des élévations et abaissements de températures au niveau des jonctions telles que 42 et 43 entre dépôts 34 et ruban 33.

A la fin de la période d'activation la palette de relais 37 est appliquée contre la borne 36, ce qui, d'une part, interrompt le passage du courant d'intensité I entre les extrémités 38 et 39 du circuit thermoélectrique 31 et donc la cessation de l'échauffement par effet Joule dans ce circuit, et, d'autre part, la possibilité de réaliser par le circuit 31 soumis à l'effet Seebeck la mesure de la différence de température entre un couple de jonctions telles que 42 et 43, les f.c.e.m. Seebeck correspondant aux différents couples 42-43 étant connectés en série par le ruban 33. Cette f.c.e.m. est amplifiée dans l'amplificateur différentiel 35 et elle est disponible sur la sortie 35c de celui-ci en tant que tension $V_s$.

Juste avant le passage de la palette 37 de la borne 40 à la borne 36, le circuit 31 était traversé par le courant I. L'interruption de l'alimentation du circuit 31 annule instantanément la chute ohmique $R_c I$. Les écarts de température entre des jonctions adjacentes telles que 42 et 43 n'étant plus entretenus par l'effet Peltier (qui disparaît lorsque I devient nul), les écarts de température distribués sur la surface du circuit 31 tendent vers zéro avec une constante de temps qui dépend des échanges thermiques avec le milieu environnant.

Du fait de cette décroissance exponentielle des différences de température, la f.e.m. $V_s$ mesurée en l'absence de courant I n'est égale à $n.a.\Delta T$ ($\Delta T$ pouvant être positif ou négatif) qu'à l'instant où le courant I est annulé dans le circuit. Il est donc capital d'effectuer la mesure pendant un temps très court, au moment où I passe par zéro. De ce fait il n'est pas possible pratiquement d'utiliser le montage théorique de la figure 9 avec un relais de type électromagnétique ou analogue, car le temps de commutation d'un tel relais est du même ordre de grandeur que la constante de temps du circuit thermoélectrique.

On peut avoir recours, pour pallier cet inconvénient, au circuit représenté sur la figure 10 comportant deux diodes 44 et 45 en série avec des résistances 46 et 47 respectivement.

Sur la figure 10 on retrouve le circuit thermoélectrique 31 représenté schématiquement et l'amplificateur différentiel 35 à entrées 35a et 35b et à sortie 35c. Le montage de la figure 10 comporte également une résistance 48.

Le circuit à pont de la figure 10, qui comporte les diodes 44 et 45 dans ses branches supérieures, assure que le circuit thermoélectrique 31 n'est alimenté par le courant d'intensité I que lorsque le pont est alimenté par une tension négative. Afin que le circuit thermoélectrique soit en régime stationnaire autorisant ainsi la mesure directe de la conductivité thermique de l'environnement du capteur, il est nécessaire que la durée de l'alternance positive (période de mesure) soit très faible par rapport à la constante de temps caractéristique du circuit thermoélectrique. D'autre part une fréquence de mesure élevée permet d'obtenir une information pouvant très facilement être filtrée en temps réel, améliorant ainsi la précision. Dans ces conditions, le choix d'une fréquence de mesure de 200 Hz avec une période de mesure de 200 µs conduit à de très bons résultats.

Un bloqueur 35e disposé à la sortie de l'amplificateur 35 et déclenché en 35f au début de la période de mesure permet de filtrer l'information et de la maintenir constante jusqu'à la période suivante. La sortie du bloqueur 35e est disponible en 35g.

On notera que cette disposition différencie nettement le procédé selon l'invention du procédé selon le brevet Battelle susmentionné Europe 0 070 801 qui étant une méthode de régime transitoire ne permet pas de donner directement une grandeur thermique caractéristique d'un milieu, mais une combinaison de deux grandeurs: résistance thermique et capacité thermique ou effusivité et diffusivité.

Parallèlement à l'ensemble série 44-46-31, l'ensemble symétrique 47-45-48 (les résistances 46 et 47 ayant même valeur ohmique, tandis que la résistance 48 a une valeur ohmique égale à celle du circuit 31, et les diodes 44 et 45 étant identiques) permet d'imposer sur la seconde entrée 35b (entrée négative) de l'amplificateur 35 un potentiel approximativement égal, ce qui empêche la saturation de l'amplificateur différentiel 35 et évite un temps de récupération important.

L'avantage de la disposition de la figure 10 est de pouvoir opérer à courant nul (I = 0), ce qui permet d'éliminer les dérives dues à la variation, en fonction de la température de la résistance électrique du circuit thermoélectrique 31.

Le montage de la figure 10 peut être rendu différentiel: un montage différentiel de ce type est illustré sur la figure 11 sur laquelle on retrouve les principaux éléments de la figure 10 (résistances 46 et 47, diodes 44 et 45, amplificateur différentiel 35 à entrée positive 35a, entrée négative 35b et sortie 35c). Toutefois à la place d'un seul circuit thermoélectrique 31 on prévoit deux circuits thermoélectriques 31a et 31b, ce dernier venant remplacer la résistance 48 du montage de la figure 10.

Dans l'ensemble de la figure 11 les deux circuits thermoélectriques 31a et 31b, de même résistance ohmique, sont connectables aux entrées positive et négative 35a et 35b respectivement de l'amplificateur différentiel 35.

Les tensions $V'_a$ et $V''_a$ de circuits des figures 10 et 11 sont données par les formules suivantes:
– pour le circuit de la figure 10:

$$V'_a = n.a.\Delta T + (R_{c'} - R_a)I,$$

dans laquelle $R_c'$ représente la valeur ohmique de la résistance 48 et $R_a$ la valeur ohmique de chacune des résistances 46 et 47;
– pour le circuit de la figure 11, en désignant par $R_{ca}$ et $R_{cb}$ les valeurs ohmiques des résistances des circuits thermoélectriques 31a et 31b respectivement et $n.a.\Delta T_a$ et $n.a.\Delta T_b$ les f.c.e.m. induites par effet Seebeck dans chacun des circuits thermoélectriques 31a et 31b respectivement, les tensions d'entrée $V_{ca}$ et $V_{cb}$ sur les entrées 35a et 35b de l'amplificateur différentiel 35 sont les suivantes pendant l'alternance négative, les circuits thermoélectriques 31a et 31b étant alimentés par le même courant I:

$$V_{ca} = R_{ca}I + n.a.\Delta T_a$$
$$V_{cb} = R_{cb}I + n.a.\Delta T_b$$

Pendant la phase de mesure le courant I s'annule et la tension de sortie $V''_a$ de l'amplificateur différentiel 35 est proportionnelle à $n.a.(\Delta T_a - \Delta T_b)$, les grandeurs $\Delta T_a$ et $\Delta T_b$ pouvant être positives ou négatives.

La tension mesurée $V''_a$ est donc proportionnelle à l'écart entre les différences de température moyennes $\Delta T_a$ et $\Delta T_b$ présentes sur chacun des circuits thermoélectriques, ce qui permet de déterminer tout paramètre affectant l'état d'un seul des deux circuits thermoélectriques.

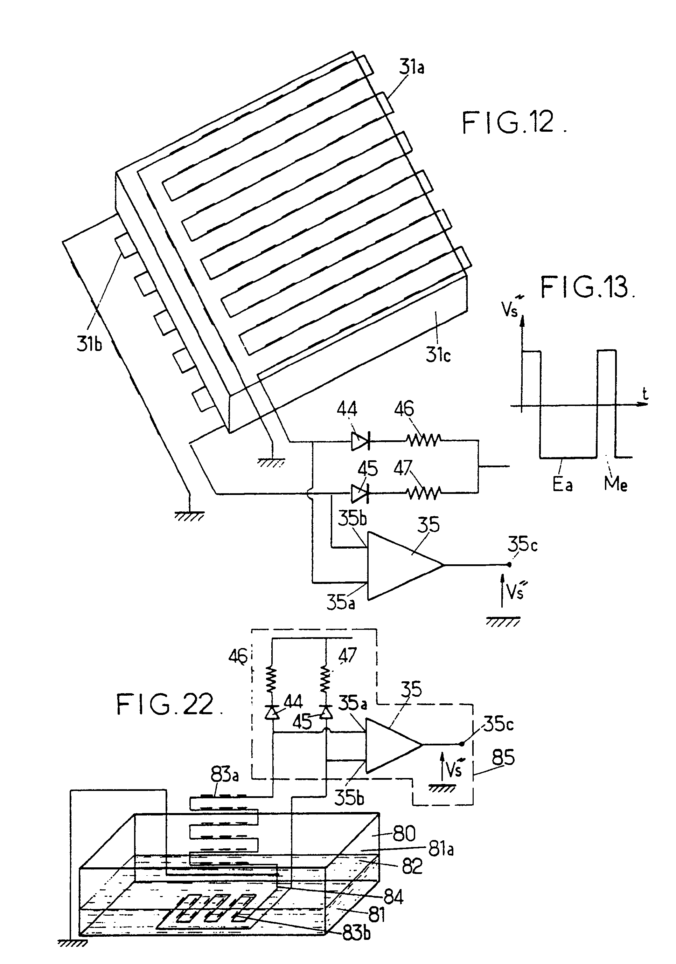

Sur la figure 12 on a illustré plus en détail un mode de réalisation du circuit de la figure 11 avec deux circuits thermoélectriques 31a et 31b disposés de part et d'autre d'une plaquette en kapton 31c constituant support pour ces deux circuits.

Sur cette figure 12 on retrouve les diodes 44 et 45 et les résistances 46 et 47, ainsi que l'amplificateur différentiel 35 à entrées positive 35a et négative 35b, associés respectivement aux circuits 31a et 31b, et la sortie 35c débitant la tension $V''_a$.

La variation de celle-ci en fonction du temps t est illustrée sur la figure 13 sur laquelle les périodes d'activation Ea et de mesure Me sont illustrées.

Sur la figure 13 on voit les changements de signe de $V''_a$ entre périodes d'activation Ea et périodes de mesure Me.

Une autre manière de détecter les différences de température engendrées dans un circuit thermoélectrique d'activation consiste à utiliser deux pistes, par exemple en constantan, revêtues chacune de dépôts électrolytiques séparés, par exemple en cuivre, qui sont disposées parallèlement et assez proches l'une de l'autre pour augmenter au maximum le couplage thermique entre ces deux circuits.

Dans ces conditions toute variation de la différence de température entre les jonctions thermoélectriques du circuit d'activation peut être détectée par la seconde piste qui constitue une piste de mesure. On donnera d'ailleurs ci-après des modes de réalisation d'un dispositif thermoélectrique à deux pistes.

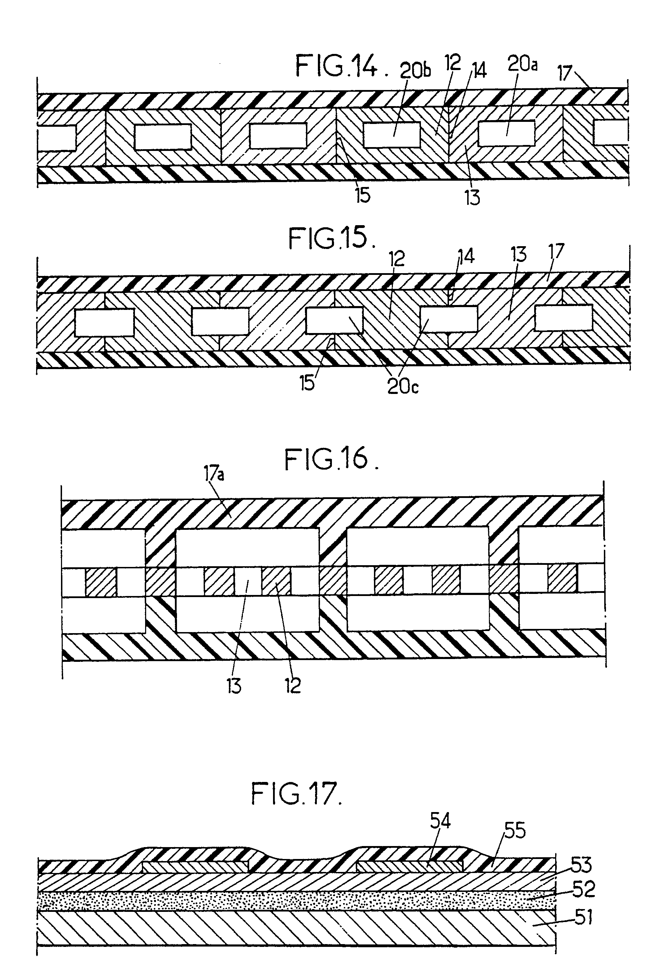

On va maintenant décrire, avec référence aux figures 14 à 21, d'autres modes de réalisation que celui illustré sur la figure 3 d'un circuit thermoélectrique; ces figures 14 à 21 ne représentent (comme la figure 3) qu'une partie du circuit, l'ensemble du circuit pouvant chaque fois être du type méandriforme analogue à celui de la figure 5.

En partant du circuit de la figure 3, il est aisé de constater qu'un circuit thermoélectrique constitué par un ruban en une première matière conductrice, telle que le constantan, disposé sur un support en une matière isolante, telle que le kapton, et revêtu sur l'autre face de dépôts électrolytiques séparés en une seconde matière conductrice, telle que le cuivre, doit, pour être très sensible à l'environnement thermique, être conçu de façon à augmenter au maximum la résistance thermique suivant la direction tangentielle du circuit.

Pour augmenter cette résistance thermique, on peut, comme illustré sur les figures 14 et 15, ménager des trous dans le circuit thermoélectrique à ruban de constantan et à dépôts de cuivre, ces trous étant disposés de manière à n'engendrer aucune dissymétrie géométrique, contrairement à ce qui est essentiel dans le cas des brevets ANVAR précités n° 2.471.055, 2.536.536 et 2.598.803.

Sur les figures 14 et 15 on retrouve le support en kapton 17, le ruban de constantan 13 et les dépôts électrolytiques 12 de la figure 3; dans le mode de réalisation de la figure 14, des trous du type "trous gravés" 20a et 20b respectivement sont réalisés dans les portions de ruban en constantan, non revêtues de dépôt de cuivre électrolytique, et dans les dépôts de cuivre électrolytique; par contre dans le cas de la figure 15 des trous gravés 20c sont disposés de part et d'autre des zones de contact 14 et 15 entre dépôts électrolytiques et ruban de constantan.

Une autre manière d'augmenter la sensibilité d'un circuit thermoélectrique selon l'invention aux influences exérieures, c'est-à-dire aux influences de la grandeur physique à mesurer dans le milieu ambiant, consiste à réduire le plus possible les dimensions du support isolant, avantageusement en kapton, et/ou à diminuer l'épaisseur du circuit thermoélectrique.

Ainsi au lieu d'utiliser un support continu en matière isolante, comme illustré sur les figures 3, 5, 14 et 15, on peut avoir recours à un cadre en matière isolante, comme dans le mode de réalisation de la figure 16. Sur cette figure on retrouve un ruban 13 en une première matière conductrice, telle que le constantan, des dépôts électrolytiques 12, par exemple en cuivre, mais au lieu d'un support continu (tel que 17 sur la figure 3) en une matière isolante, telle le kapton, on prévoit un cadre 17a en matière isolante sur lequel est collé le ruban continu 13 par sa face inférieure.

On peut réaliser le support 17a de la figure 16 d'une manière pratique en disposant, sous le ruban 13, avantageusement de forme méandriforme comme illustré sur la figure 5, une plaquette de support, avantageusement rectangulaire, en protégeant les parties du support qui doivent constituer le cadre, c'est-à-dire être conservées, au moyen d'une résine photosensible dont la partie sensibilisée, à travers un cache ayant la forme du cadre 17a, est éliminée, et en plongeant ensuite le circuit dans une solution basique qui élimine les portions du support qui doivent être supprimées et ne laisse que le cadre 17a.

Sur la figure 17 on a illustré, en coupe, une portion, d'un mode de réalisation de circuit thermoélectrique constitué non plus sous la forme d'un circuit imprimé, mais sous la forme d'un circuit "imprimé" à semiconducteur.

On part d'une base 51, par exemple en aluminium, sur laquelle on forme un substrat 52 isolant; celui-ci peut être par exemple constitué par une pellicule d'alumine formée sur la base 51 en aluminium ou par une couche de silice. Sur le support 52 est disposé un ruban 53 en une matière semiconductrice ayant un fort pouvoir thermoélectrique, telle que le germanium de type N. Quant aux dépôts 54 en une seconde matière thermoélectrique, ils peuvent être réalisés en or. Enfin une couche de protection 55 en résine assure une protection du circuit thermoélectrique 53-54 proprement dit.

On a indiqué précédemment qu'il pouvait dans certains cas être avantageux de prévoir non pas un seul circuit thermoélectrique, mais plusieurs circuits thermoélectriques, au moins l'un de ceux-ci mettant en oeuvre essentiellement l'effet Peltier et constituant au moins un circuit d'activation et au moins un autre de ces circuits mettant en oeuvre l'effet Seebeck et constituant au moins un circuit de mesure.

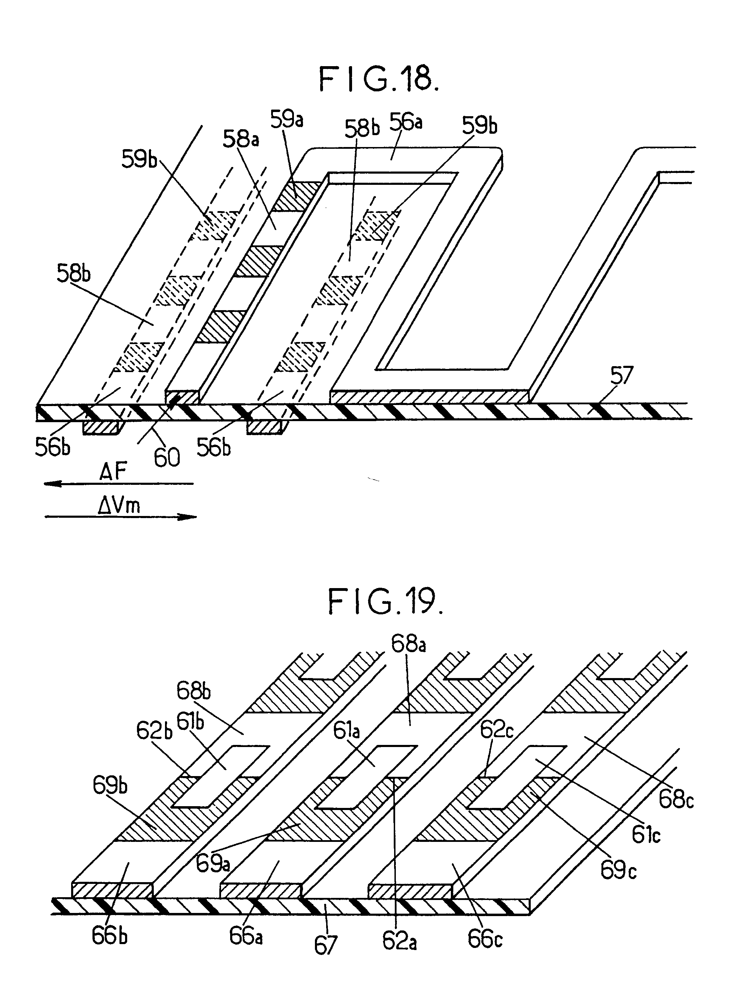

Sur la figure 18 on a représenté, partiellement en perspective par-dessus, une portion d'un tel système avec deux circuits, à savoir un circuit thermoélectrique d'activation 56a, illustré en traits pleins, disposé au-dessus d'un support 57 en kapton, et un circuit de mesure 56b, illustré en traits interrompus, disposé sous le support 57.

Chacun de ces circuits 56a, 56b comporte un ruban 58a, 58b respectivement, en une première matière conductrice telle que le cuivre, et des dépôts 59a, 59b, en une seconde matière conductrice telle que le cuivre électrolytique.

Le circuit 56a d'excitation est alimenté en un courant continu 60 d'intensité I, d'où mise en oeuvre de l'effet Peltier, tandis que le circuit de mesure 56b détecte, par effet Seebeck, les variations de température induites par la piste d'excitation 56a sous l'effet Peltier, ce circuit 57 étant connecté à des moyens de mesure de la f.c.e.m. Seebeck, par exemple du type illustré sur les figures 10 et 11.

Le circuit de la figure 18 est particulièrement avantageux pour mesurer un débit de gaz, la f.e.m. développée dans le circuit de mesure 56b dépendant de la direction d'écoulement du débit gazeux par rapport à la surface de l'ensemble, c'est-à-dire par rapport au plan médian du support 57. Dans le cas d'un écoulement perpendiculaire à ce plan, la f.e.m. Seebeck est directement proportionnelle au débit du fluide.

A titre de variante, au lieu d'avoir un seul circuit de mesure 56b on peut prévoir deux circuits de mesure, les deux portions référencés 56b (représentées en traits interrompus sur la figure 18) faisant alors partie de deux circuits de mesure distincts; dans ce cas on effectue la mesure de la f.c.e.m. différentielle entre les deux circuits de mesure par un montage selon la figure 11 par exemple.

La f.e.m. $\Delta Vm$ est proportionnelle au débit gazeux $\Delta F$ dans lequel est disposé le dispositif. Lorsque le débit change de sens, $\Delta Vm$ change de sens; $\Delta Vm$ est nul uniquement pour un débit nul (alors que la f.e.m. détectée dans le circuit d'excitation n'est pas sensible à l'orientation de la perturbation). Le fait d'utiliser un circuit d'excitation et deux circuits de mesure présente comme avantage d'avoir une grandeur centrée ayant un zéro fiable.

Pour accroître la sensibilité du dispositif de la figure 18 à un ou deux circuits de mesure, vis-à-vis des influences extérieures, par exemple celles d'un fluide qui s'écoule perpendiculairement au plan médian du support 57, on peut pratiquer des trous dans les circuits thermoélectriques.

Sur la figure 19 on a illustré une variante du mode de réalisation de la figure 18. Dans cette variante, on a prévu un circuit d'excitation 66a et deux circuits de mesure 66b, 66c disposés du même côté du support de kapton 67. Des trous 61a, 61b, 61c sont pratiqués tant dans le circuit d'excitation 66a que dans les circuits de mesure 66b, 66c respectivement, de part et d'autre des zones de contact 62a, 62b, 62c du ruban 68a, 68b, 68c, en une première matière conductrice telle que le constantan, et des dépôts 69a, 69b, 69c, en une seconde matière conductrice telle que le cuivre.

De tels trous non seulement améliorent le couplage entre le circuit d'activation 66a et les circuits de mesure 66b, 66c, mais également augmentent les écarts de températures sur la surface de chaque circuit thermoélectrique d'activation ou de mesure.

Le couplage entre un circuit d'activation et un ou plusieurs circuits de mesure peut être encore augmenté par une imbrication plus poussée de ces circuits en donnant une structure géométrique emboîtée à ces circuits.

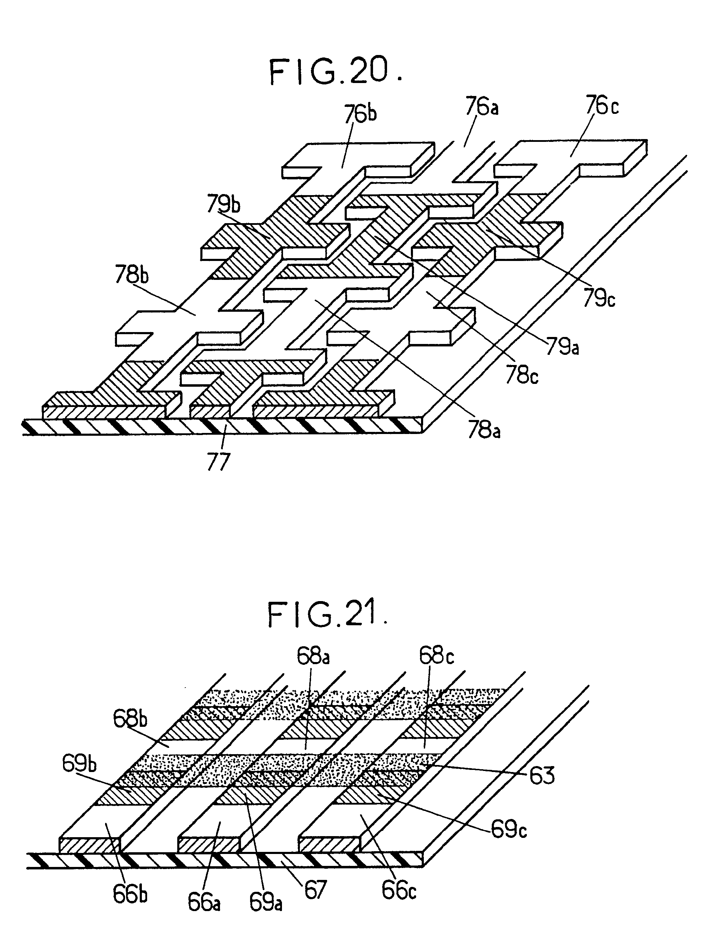

Ainsi dans le mode de réalisation de la figure 20 chaque circuit thermoélectrique 76a, 76b, 76c, disposé sur un support commun 77 en kapton, comporte une série d'excroissances latérales:

– le circuit d'excitation 76a est constitué par un ruban 78a en constantan avec des dépôts 79a en cuivre, les dépôts 79a et les zones du ruban 78a non revêtues de cuivre ayant la forme d'un I; et

– les deux circuits de mesure 76b, 76c (ou le circuit unique de mesure) présentent une forme complémentaire avec un ruban 78b, 78c en constantan et des revêtements 79b, 79c en cuivre, les dépôts 79b, 79c et les zones du ruban 78b, 78c non revêtues de cuivre ayant la forme du signe +.

On constate aisément que grâce à la configuration géométrique imbriquée des circuits 76a, 76b, 76c de la figure 20, la transmission thermique entre le circuit d'activation 76a et les circuits de mesure 76b, 76c est nettement améliorée.

Dans le mode de réalisation de la figure 21, on retrouve une structure voisine de celle de la figure 19 (mais sans trous); sur la figure 21 on a utilisé les mêmes références que sur la figure 19 pour les éléments correspondants.

Pour améliorer la sensibilité aux influences extérieures, on a prévu de coupler les dépôts électrolytiques en cuivre 69a, 69b, 69c en regard au moyen de couches de résine illustrées schématiquement en 63.

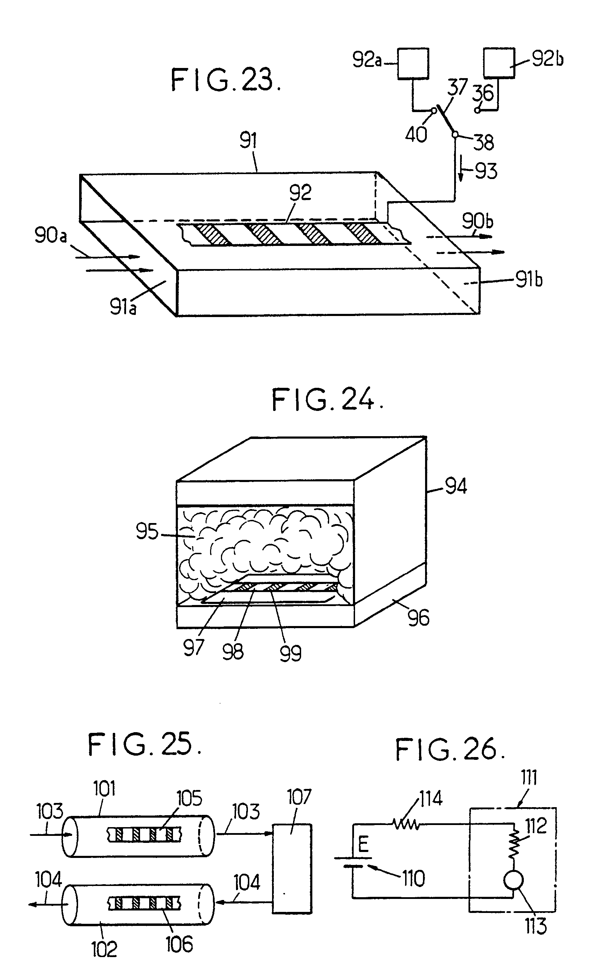

Après avoir décrit et illustré plusieurs modes de réalisation de circuits thermoélectriques pour la mise en oeuvre de l'invention, on va décrire quelques applications particulières de ces circuits, avec référence aux figures 22 à 25.

D'une manière générale, un circuit thermoélectrique selon l'invention subit l'influence du milieu ambiant dans lequel il est placé du fait d'échanges thermiques entre le milieu ambiant et lui, et c'est d'ailleurs ce qui permet de mesurer par un tel circuit certains paramètres du milieu ambiant, par exemple le niveau d'un liquide dans un récipient, le débit et/ou la vitesse d'un débit fluide ou un changement d'état physique (congélation, point de rosée) d'un milieu, du fait de la perturbation des propriétés thermiques du milieu au moment du changement d'état physique, ou de compter des calories.

Sur la figure 22 on a représenté une jauge mettant en oeuvre un circuit selon l'invention pour déterminer la hauteur du liquide dans un récipient 80; sur cette figure le liquide est référencé 81 et sa surface supérieure libre est désignée par 82.

La jauge selon l'invention comporte deux circuits thermoélectriques 83a et 83b dont le conducteur de jonction 84 est mis à la masse.

Les deux circuits thermoélectriques 83a et 83b sont connectés à un circuit électronique 85 du type illustré sur la figure 11, c'est-à-dire comportant des diodes 44 et 45, des résistances 46 et 47 et un amplificateur différentiel 35 à entrées positive 35a et négative 35b, la tension de sortie étant disponible en 35c en tant que tension $V''_s$. Une résistance, telle que la résistance 48 de la figure 10, pourrait éventuellement être ajoutée au circuit 85 de la figure 22.

Le circuit 83b est disposé au fond du réservoir 80 et il se trouve, sauf quand le réservoir est vide, immergé dans le liquide 81. Par contre le circuit thermoélectrique 83a n'est que partiellement immergé dans le récipient 80 et la portion immergée du circuit 83a dépend du niveau du liquide dans le récipient 80, la portion immergée étant celle se trouvant sous la surface libre 82, tandis que la partie émergée du circuit 83a est celle qui se trouve au-dessus de la surface 82.

La variation de la f.c.e.m. Seebeck à l'entrée positive 35a de l'amplificateur différentiel 35 est une fonction linéaire de la position de la surface libre 82 du liquide dans le réservoir 80, car elle est une fonction linéaire de la longueur du circuit 83a qui est immergé, du fait que les coefficients de transmission de chaleur du liquide 81 et du gaz 81a sont différents. La f.c.e.m. sur l'entrée 35b de l'amplificateur 35, et qui est engendrée par le circuit 83b complètement immergé (sauf lorsque le réservoir 80 est vide), le circuit 83b étant par exemple collé au fond du réservoir, est constante et de ce fait la sortie V"$_s$ est une fonction linéaire du niveau du liquide 81 dans le réservoir 80.

Si l'on a prévu deux circuits 83a et 83b c'est pour réaliser une compensation des perturbations dues à une modification de la température dans le réservoir 80, les f.c.e.m. des circuits 83a et 83b étant mesurées en différentiel par l'amplificateur 35 et une variation de température ayant un effet semblable sur les circuits 83a et 83b.

Il reste cependant, malgré la mise en oeuvre de deux circuits 83a et 83b montés en différentiel, que la tension 35c reste fonction de la température absolue du liquide 81, mais cette dépendance est faible et elle peut en tous les cas être déterminée au moyen d'une mesure de température, à savoir celle du liquide dans le récipient 80. La figure 26 illustre un autre moyen de corriger l'influence de la compensation.

Une autre application de l'invention est la mesure de la vitesse de déplacement et/ou du débit d'un courant fluide.

On a déjà indiqué précédemment, avec référence aux figures 18 et 19, comment l'on pouvait procéder à la mesure d'un débit de fluide et/ou de sa vitesse.

Sur la figure 23 on a illustré un mode de réalisation particulier de la mise en oeuvre de l'invention pour détecter la vitesse de déplacement et/ou le débit d'un courant fluide.

Sur cette figure, le courant fluide entrant 90a traverse un conduit 91 de forme générale parallélépipédique rectangle avec une ouverture d'entrée 91a et une ouverture de sortie 91b, dont il ressort en tant que courant fluide sortant 90b.

Dans ce conduit 91, avantageusement pratiqué dans un bloc métallique, est disposé un circuit thermoélectrique 92 unique pour l'activation et la mesure, ou sont disposés au moins un circuit d'activation et au moins un circuit de mesure; les échanges de chaleur entre le ou les circuits 92 et la boîte 91 sont fonction du débit et/ou de la vitesse du courant fluide, d'une part, ainsi que de la nature et de la température du courant fluide, d'autre part.

Le circuit 92 est connectable à un système d'activation 92a et à un système de mesure 92b, en 40 et 36 respectivement, par une palette 37 mobile autour d'une borne 38, par exemple comme illustré sur la figure 9, en y remplaçant le circuit 31, avec éventuellement les perfectionnements des figures 10 et 11 en ce qui concerne le système électronique réalisant la mesure. Par conséquent le circuit 92, lorsqu'il est unique, reçoit pendant une période d'activation du système 92a un courant 93 d'intensité I pour la mise en oeuvre de l'effet Peltier et débite pendant une période de mesure une f.c.e.m. Seebeck, vers le système électronique de mesure 92b.

Comme indiqué précédemment, la mesure dépend de la nature du fluide et c'est pour cela que l'on étalonne d'abord l'appareil avec un courant de fluide de même nature que celui dont on veut mesurer par exemple le débit, la f.c.e.m. Seebeck étant, pour un même fluide et à une même température, une fonction linéaire du débit par exemple du courant fluide.

Le dispositif de la figure 23 peut également servir à effectuer des analyses chimiques en déterminant par exemple, dans un mélange de deux gaz, la proportion de chacun des gaz. Il suffit dans ce cas de faire passer dans le dispositif de la figure 23 un des deux gaz en tant que gaz de référence, puis le mélange gazeux, la f.c.e.m. Seebeck étant fonction, en général linéairement, de la proportion du second gaz dans le mélange.

Référence étant maintenant faite à la figure 24, on va décrire un dispositif permettant de déterminer le point de rosée d'une vapeur ou d'un gaz humide.

Le dispositif illustré sur la figure 24 comprend une boîte parallélépipédique 94 dans laquelle est disposée la vapeur ou le gaz humide dont la masse est référencée 95. Au fond de la boîte 94 est disposé un module 96 de refroidissement à effet Peltier et sur lequel on a disposé un circuit thermoélectrique selon l'invention à support 97 en kapton, ruban 98 en constantan et dépôts 99 en cuivre.

Lorsque la température diminue progressivement dans la boîte 94 par la mise en oeuvre de l'effet Peltier dans le module 96, il y a à un moment donné condensation de l'humidité sur le module froid 96 et il suffit de détecter la présence de la pellicule liquide de très faible épaisseur, qui se dépose au fond de la boîte 94 sur le module 96 et qui baigne alors le circuit thermoélectrique 98, 99, et de mesurer la température du circuit.

La f.c.e.m. Seebeck fournie par le circuit 98, 99 varie brusquement dès qu'il y a apparition de rosée, ce qui permet de déterminer le point de rosée, en repérant la température au moment de l'apparition de la rosée par effet Seebeck grâce au circuit 98, 99 et à l'électronique associée du type illustré sur les figures 10 à 12.

L'invention peut également s'appliquer pour réaliser un compteur de calories et un mode de réalisation particulier, à cet effet, est illustré sur la figure 25.

Le dispositif comporte deux tubes aller 101 et retour 102 parcourus respectivement par le courant fluide entrant 103 de débit $d_1$ et le courant fluide sortant 104 de débit $d_2$. En régime permanent $d_1 = d_2 = d$. Si on appelle $\underline{c}$ le pouvoir calorifique massique du fluide 103, 104, la quantité à mesurer par le compteur à calories est: $c.d(T_1 - T_2)$, en appelant $T_1$ la température du fluide entrant 103 et $T_2$ la température du fluide sortant 104.

En régime non permanent, la formule précédente devient $c(d_1.T_1 - d_2.T_2)$. La quantité à mesurer est donc fonction de la différence entre le débit calorifique entrant, d'une part, et le débit calorifique sortant, d'autre part.

Dans le tube aller 101 est disposé un premier circuit thermoélectrique 105 selon l'invention et dans le tube retour 102 est disposé un second circuit 106 selon l'invention, ces deux circuits 105, 106 étant montés en différentiel, par exemple comme les deux circuits 83a et 83b de la figure 22; la tension de sortie $V''_s$ est fonction des calories dépensées dans le circuit 107 d'utilisation des calories entre le tube aller 101 et le tube retour 102.

Enfin sur la figure 26 on a illustré, à titre d'exemple, un schéma électrique permettant de compenser les dérives produites par les variations de température dans un cicuit thermoélectrique mettant en oeuvre l'invention.

En effet si on veut obtenir une mesure qui ne dépende que du milieu environnant, c'est-à-dire des seuls écarts de température $\Delta T$ mentionnés ci-dessus, mais indépendante de la température moyenne du circuit thermoélectrique, il faut compenser l'influence de cette température moyenne sur le circuit.

Or la f.c.e.m. débitée par un circuit thermoélectrique selon l'invention dépend de sa température moyenne, car le pouvoir thermoélectrique de chacune des deux matières conductrices ou semiconductrices du circuit n'est pas une constante mais dépend linéairement de la température moyenne du circuit.

Par ailleurs, les sources thermiques (par échauffement ou refroidissement) produites par effet Peltier dépendent également de la température moyenne, car elles sont proportionnelles à $TI$.

Une solution consiste à faire varier $I$ (intensité du courant produisant l'effet Peltier) pour compenser les influences de la température; on peut à cet effet alimenter le circuit thermoélectrique non pas par un courant d'intensité constante $I$, mais par une tension constante $E$.

Sur la figure 26 on a illustré en 110 une source de tension constante $E$ qui alimente à travers une résistance 114, de valeur $Ri$, le circuit thermoélectrique 111 matérialisé par une résistance 112 et une source de f.c.e.m. 113 (un peu à la manière des figures 2 et 4).

La f.e.m. de la source 113 est proportionnelle à $n.a.\Delta T$ et dépend donc de la température absolue $T$. Lorsque $T$ augmente, la contre-réaction naturelle $n.a.\Delta T$ augmente compte-tenu des effets de température; donc l'intensité $I$ du courant produit par la source 113 et appliqué au circuit 111 diminue.

En fait pour réaliser une compensation significative du courant, il faut utiliser un circuit thermoélectrique dont la valeur ohmique de la résistance 112 augmente avec la température. A cet effet on remplace le constantan par du nickel (dont la résistance augmente plus fortement avec la température) pour réaliser le ruban métallique du circuit thermoélectrique ($a.To > 1$).

On voit que l'on peut ainsi obtenir un dispositif selon l'invention compensé en température, en utilisant la variation naturelle de la résistance électrique $R_c$ du circuit thermoélectrique 111 et en ajustant la valeur $Ri$ de la résistance 114.

Il suffit d'obtenir $Ri = R_{\infty}(a.To - 1)$ avec $To = 273K$, $R_{\infty}$ : résistance électrique à 0°C du capteur et $a$: coefficient de température du capteur.

Comme il va de soi, l'invention ne se limite nullement aux modes d'application et de réalisation qui ont été plus spécialement envisagés; elle en embrasse, au contraire, toutes les variantes.

## Revendications

1. Procédé pour mesurer une grandeur variable apte à influencer thermiquement un milieu, caractérisé par le fait que l'on utilise au moins un circuit thermoélectrique comportant en série une pluralité de thermocouples élémentaires et apte donc à mettre en oeuvre à la fois l'effet Peltier et l'effet Seebeck, qu'on fait circuler, pendant une période dite d'activation, à travers ce circuit ou au moins un des circuits, un courant électrique unidirectionnel pour engendrer, par effet Peltier, aux jonctions des thermocouples du ou des circuits traversés par le courant, des modifications de températures, positives en une partie de ces jonctions et négatives en l'autre partie de ces jonctions, et qu'on détermine, pendant une période dite de mesure qui suit ladite période d'activation, la différence de potentiel engendrée par l'effet Seebeck aux bornes du circuit unique ou d'au moins un autre de ces circuits (thermiquement couplé à au moins un circuit traversé par ledit courant), en l'absence d'application de courant aux bornes de ce ou ces circuits de mesure.

2. Procédé selon la revendication 1, caractérisé par le fait que l'on utilise un seul circuit thermoélectrique qui est successivement connecté pendant une période d'activation à une source de courant et pendant une période de mesure à une unité de mesure déterminant la différence de potentiel engendrée dans ce circuit par l'effet Seebeck.

3. Procédé selon la revendication 1, caractérisé par le fait qu'il comprend un circuit thermoélectrique d'activation, qui est connecté au moins pendant une période d'activation à une source de courant, et au moins un circuit thermoélectrique de mesure, qui est connecté pendant une période de mesure à une unité de mesure déterminant la différence de potentiel engendrée dans le ou les circuits de mesure par l'effet Seebeck.

4. Dispositif pour la mise en oeuvre du procédé selon l'une quelconque des revendications précédentes, caractérisé par le fait qu'il comporte en combinaison:
   – au moins un circuit (1; 11; 11a; 31, 31a, 31b; 56a, 56b; 66a, 66b, 66c; 76a, 77b, 76c; 83a, 83b; 92; 97-98-99; 105, 106; 111) constitué par une succession de deux types d'éléments (2, 3; 12, 13; 33, 34; 58a, 59a; 58b, 59b; 68a, 69a; 68b, 69b; 68c, 69c; 78a, 79a; 78b, 79b; 78c, 79c; 98, 99) conducteurs ou semiconducteurs en série, ces deux types ayant des pouvoirs thermoélectriques différents et étant disposés en alternance de manière à réaliser deux types de jonctions alternants de thermocouples;
   – une source de courant électrique unidirectionnel (6, 16, 41, 92a, 110, 114);
   – des moyens (37) pour connecter cette source de courant aux bornes de ce circuit unique ou d'au moins de ces circuits, dit d'activation, pendant une première période de temps constituant une période d'activation;
   – des moyens (35) pour mesurer, pendant une seconde période de temps constituant une période de mesure, la différence de potentiel aux bornes de ce circuit unique ou d'au moins un de ces circuits, dit de mesure et différent dudit au moins un circuit auquel la source de courant est connectable, le ou les circuits de mesure étant thermiquement couplés au ou aux circuits d'activation; et
   – des moyens pour déterminer à partir de la mesure de cette différence de potentiel la variation à mesurer de ladite grandeur physique.

5. Dispositif selon la revendication 4, caractérisé par le fait que le circuit électrique est constitué par un circuit imprimé comportant, sur un support (17, 32, 31c, 17a, 52, 57, 67, 77, 97), en une matière isolante, un ruban méandriforme (13; 33; 56a, 56b; 66a, 66b, 66c; 76a, 76b, 76c; 98) en une première matière conductrice et, sur ce ruban, des îles (12; 34; 59a, 59b; 69a, 69b, 69c; 79a, 79b, 79c; 99) de revêtement disposées l'une derrière l'autre, mais séparées les unes des autres dans le sens du ruban, le revêtement étant réalisé en une seconde matière conductrice, beaucoup plus conductrice de l'électricité que la première.

6. Dispositif selon la revendication 5, caractérisé par le fait que la première matière conductrice est le constantan ou le nickel et la seconde matière conductrice le cuivre.

7. Dispositif selon l'une quelconque des revendications 4 à 6, caractérisé par le fait que le circuit thermoélectrique ou chaque circuit thermoélectrique est méandriforme.

8. Dispositif selon l'une quelconque des revendications 5 à 7, caractérisé par le fait que des trous (20a, 20b) sont pratiqués au centre de chaque île et de chaque zone du ruban non revêtue d'île.

9. Dispositif selon l'une quelconque des revendications 5 à 7, caractérisé par le fait que des trous (20c) sont pratiqués à cheval sur une zone de contact d'une île et d'une zone du ruban non revêtue d'île.

10. Dispositif selon l'une quelconque des revendications 5 à 9, caractérisé par le fait que le support en matière isolante a la forme d'un cadre (17a), de manière que le ruban ne soit que partiellement supporté par le support.

11. Dispositif selon la revendication 4, caractérisé par le fait que le circuit thermoélectrique ou chaque circuit thermoélectrique est constitué sous la forme d'un "circuit intégré" comportant une couche de support (52) en une matière isolante, un ruban (53) en une matière semiconductrice, des îles (54) en une matière bien meilleure conductice que celle constituant le ruban et un revêtement de résine (55) qui couvre les îles et les parties du ruban non recouvertes d'île.

12. Dispositif selon l'une quelconque des revendications 4 à 11, caractérisé par le fait qu'il y a au moins un circuit thermoélectrique d'activation et au moins un circuit thermoélectrique de mesure emboîtés, de manière à réaliser un couplage thermique aussi bon que possible entre le ou les circuits d'activation (76) et le ou les circuits de mesure (76b, 76c).

13. Dispositif selon l'une quelconque des revendications 4 à 12, caractérisé par le fait que les moyens de mesure comportent un amplificateur différentiel à deux entrées (35a, 35b), dont l'une (35a) reçoit la sortie du circuit thermoélectrique unique et dont l'autre (35b) est connectée à la masse à travers une résistance ayant une valeur ohmique sensiblement égale à celle du circuit thermoélectrique unique, un bloqueur (35e) étant avantageusement relié à la sortie de l'amplificateur et déclenché lors de la période de mesure.

14. Dispositif selon l'une quelconque des revendications 4 à 12, caractérisé par le fait que les moyens de mesure comportent un amplificateur différentiel à deux entrées (35a, 35b), dont l'une (35a) reçoit la sortie d'un des circuits thermoélectriques et dont l'autre (35b) reçoit la sortie d'un autre des circuits thermoélectriques et éventuellement dudit bloqueur (39e).

15. Dispositif selon la revendication 13 ou 14, caractérisé par le fait qu'une diode et une résistance en série sont connectées en amont de chacune des entrées (35a, 35b) de l'amplificateur différentiel (35) de manière à assurer la commutation du ou des circuits thermoélectriques connectés aux entrées de l'amplificateur différentiel et à compenser éventuellement la dérive en température.

16. Dispositif pour mesurer la hauteur d'un liquide dans un récipient, caractérisé par le fait qu'il comprend deux circuits thermoélectriques, dont l'un (83a) est maintenu au fond du récipient et dont l'autre (83b) est disposé verticalement pour qu'une partie variable de sa hauteur soit plongée dans le liquide (81) suivant la position de la surface libre (82) de celui-ci qui doit être repérée, un point de jonction (84) des deux circuits étant mis à la masse et l'autre extrémité de chacun des deux circuits étant connectée l'une à une première entrée (35a) et l'autre à une seconde entrée (35b) d'un amplificateur différentiel (35) pour constituer un dispositif selon la revendication 14 ou 15.

17. Dispositif pour mesurer le débit et/ou la vitesse d'un courant fluide, caractérisé par le fait qu'il comporte un conduit (91) avec une entrée (91a) et une sortie (91b) pour le courant fluide et au moins un circuit thermoélectrique (92) d'un dispositif selon l'une quelconque des revendication 4 à 15.

18. Dispositif pour déterminer le point de rosée d'une vapeur ou d'un gaz humide, caractérisé par le fait qu'il comporte une boîte (94) pour enfermer ladite vapeur ou ledit gaz (95), un module de refroidissement (96) disposé au fond de cette boîte et un circuit thermoélectrique (97, 98, 99) disposé contre ce fond et connecté à des moyens d'activation et des moyens de mesure pour constituer un dispositif selon l'une quelconque des revendications 4 à 15.

19. Compteur de calories, caractérisé par le fait qu'il comporte un premier tube (101) traversé par un courant fluide (103) qui amène les calories vers un dispositif d'utilisation (107), un second tube (102) traversé par le courant fluide (104) qui transporte les calories non utilisées dans le dispositif d'utilisation, deux circuits thermoélectriques (105, 106), et des moyens différentiels pour déterminer la différence entre la différence de potentiel engendrée par l'effet Seebeck dans le premier circuit (105) et la différence de potentiel engendrée par effet Seebeck dans le second circuit (106) afin de constituer un dispositif selon la revendication 14 ou 15.

## FIG.1.

## FIG.2.

## FIG.3.

## FIG.4.

# FIG.5.

# FIG.6.

23
21
22

# FIG.7.

23  24
25
22

# FIG.8.

24a  24b

23a  23  22

FIG.9.

FIG.10.

FIG.11.

FIG.12.

31a

31b

31c

FIG.13.

$V_s$

44    46

45    47

35b    35    35c

35a    $V_s''$

Ea    Me

t

FIG.22.

46    47

44    35a    35

45    35c

83a    35b    85

80

81a

82

84

81

83b

FIG.14 . 20b  12  14  20a  17

15  13

FIG.15 .

12  14  13  17

15  20c

FIG.16 .

17a

13  12

FIG.17 .

54  55

53
52
51

# FIG.18.

# FIG.19.

## FIG.20.

## FIG.21.

FIG.23.

FIG.24.

FIG.25.

FIG.26.